# EUROPÄISCHE PATENTSCHRIFT

(11) **EP 1 374 657 B1**
(45) Veröffentlichungstag und Bekanntmachung des Hinweises auf die Patenterteilung: **03.11.2004**
(21) Anmeldenummer: 02727251.7
(22) Anmeldetag: 19.03.2002
(51) Int. Cl.: H05K 13/04

(54) **EINRICHTUNG UND VERFAHREN ZUM ZUFÜHREN VON GEGURTETEN ELEKTRISCHEN BAUTEILEN**
DEVICE AND METHOD FOR FEEDING TAPED ELECTRICAL COMPONENTS
DISPOSITIF ET PROCEDE D'ALIMENTATION DE COMPOSANTS ELECTRIQUES SUR BANDE

(30) Priorität: 30.03.2001 DE 10115908
(43) Veröffentlichungstag der Anmeldung: 02.01.2004
(73) Patentinhaber: SIEMENS AKTIENGESELLSCHAFT, 80333 München (DE)
(72) Erfinder: LIEBEKE, Thomas, 85521 Ottobrunn (DE)
(86) Internationale Anmeldenummer: PCT/DE2002/000994
(87) Internationale Veröffentlichungsnummer: WO 2002/080643

(56) Entgegenhaltungen:
- EP-A- 0 345 061
- EP-A- 0 589 275
- US-A- 6 032 845

## Beschreibung

Die Erfindung bezieht sich auf eine Einrichtung zum Zuführen von gegurteten elektrischen Bauteilen in einer Zuführeinrichtung mit einem Antrieb zum Vorschieben eines die Bauteile aufnehmenden Gurtes, wobei die Bauteile in Taschen des Gurtes aufgenommen und schrittweise in eine definierte Abhollage transportierbar sind wobei der Antrieb einen Motor und ein von diesem angetriebenes Antriebsrad aufweist, wobei der Gurt mit Transportlöchern versehen ist, in die Transportstifte des Antriebsrades eingreifen und wobei der Antrieb mit einer Steuereinrichtung zum Verändern der Vorschublänge versehen ist.

Derartige Zuführmodule sind üblicherweise mit einem Stachelrad versehen, das mit seinen radial abstehenden Stiften in Transportlöcher des Gurtes eingreift und das in definierten Winkelschritten entsprechend dem Teilungsabstand der Taschen des Gurtes verdreht wird. Die Taschen weisen eine definierte Lagebeziehung zu den Transportlöchern auf. Auf den Zuführmodulen werden am Ende des Herstellungsprozesses im Bereich der Abholstelle Zentriermarken angebracht, die in einer definierten Lagebeziehung zu den Stiften des Stachelrades stehen und die Fertigungstoleranzen ausgleichen sollen. Es ist ferner üblich, nach dem Einbau des Zuführmodules die in einem Zuführbereich eines Bestückautomaten die Lage der Zentriermarken auf dem Zuführmodul mittels einer von einem verfahrbaren Bestückkopf angebrachten Kamera zu vermessen, um die Einbautoleranzen ausgleichen zu können. Betriebsbedingte Abweichungen im Antriebssystem des Zuführmoduls sind dabei nicht völlig zu eliminieren.

Im Zuge moderner Technologien werden die zu bestückenden Bauteile immer mehr miniaturisiert. Es ist üblich, den Bestückkopf mit einem Sauggreifer zu versehen, der auf die abzuholenden Bauteile aufgesetzt wird und diese an seine Stirnseite ansaugt. Dabei muss der Greifer in die Tasche eintauchen, um auf das Bauteil aufsetzen zu können. Die zulässigen Toleranzen zwischen dem Transportloch und der Tasche sind so groß, dass der abholende Sauggreifer nicht mit Sicherheit genau auf das abzuholende Bauteil eingestellt werden kann und auf den Taschenrand aufsetzt und dadurch das Bauteil verfehlt. Hierbei handelt es sich allerdings mindestens über einen längeren Abschnitt des Gurtes um einen systematischen Fehler.

Die Zuführeinrichtungen sind so ausgebildet, dass sie z. B. nach der EP 0 589 275 A1 mit unterschiedlichen Teilungsabständen betrieben werden können, in dem ein Antriebsmotor pro Vorschubschritt eine unterschiedliche Anzahl von Drehungen ausführt, bevor die Antriebswelle gegen einen Drehanschlag verfahren wird. Je nach Länge der Bauteile kann sich die Mittellage der Bauteiletasche in der Abhollage innerhalb eines Abholbereichs verändern. Diese Abweichung wird durch eine entsprechende Lagekorrektur des Bestückkopfes berücksichtigt.

Zum Beispiel nach der WO98/37744 A1 ist es ferner üblich, einen Positionierarm zur Führung des Bestückkopfes so anzuordnen, dass er sich in der Reihenrichtung der aneinander gereihten Zuführeinrichtungen erstreckt. Beim Abholen der verschiedenen Bauteile aus den einzelnen Zuführeinrichtungen muss dann der Positionierarm entsprechende Korrekturschritte je nach Lage des abzuholenden Bauteils ausführen.

Nach der US6032845 A ist ferner eine Zuführeinrichtung mit einem Gurtantrieb versehen, dessen Vorschublänge in Abhängigkeit vom Teilungsabstand der Bauelemente im Gurt verstellbar ist. Dieser wird durch ein Transportrad mit radial abstehenden Zähnen angetrieben, die in die Transportlöcher des Gurte eingreifen. Ein optische Sensor ist auf die Zähne gerichtet und kann so die genaue Funktionsstellung eines der Zähne überwachen.

Ferner ist durch die EP0345061 A eine modulare Zuführeinrichtung bekannt geworden, bei der der Bauelementegurt mittels eines Schiebers mit versenkbaren Transportstiften vorgeschoben werden kann. Die Hublänge des durch einen Druckluftzylinder angetriebenen Schiebers und damit die Vorschublänge des Gurtes ist mittels eines verstellbaren Anschlags auf die jeweilige Abstandsteilung des Gurtes manuell einstellbar. Eine solche Verstellung ist jeweils dann erforderlich, wenn ein Gurt mit anderer Abstandsteilung eingelegt wird.

Der Erfindung liegt die Aufgabe zugrunde, das Abholen der Bauteile im Falle einer Lageabweichung zu erleichtern.

Diese Aufgabe wird durch die Erfindung gemäß Anspruch 1 gelöst.

Durch die feinstufige Veränderbarkeit der Vorschublänge können unabhängig von ihrer Größe und von ihrer Längsabweichung im Gurt genau auf eine bestimmte Abholposition justiert werden. Dieser Justierschritt kann z. B. nach jedem Gurtwechsel durchgeführt werden, indem die tatsächliche Lage des Bauteils oder der Bauteiletasche mittels der am Bestückkopf angebrachten Kamera gemessen wird. Dieser Vorgang kann auch zwischen zwei Gurtwechseln durchgeführt werden, wenn sich insbesondere bei sehr kleinen Bauteilen die Fehlerrate beim Abholen signifikant erhöht. Ein besonderer Vorteil besteht darin, dass es auf diese Weise möglich ist, sämtliche Abholstellen einer Gruppe von Zuführeinrichtungen auf eine Linie auszurichten, so dass der Positionierarm während des Verfahrens des Vielfachbestückkopfes zu den verschiedenen Abholplätzen in einer festen Position stehen kann, wodurch sich der entsprechende Antriebs- und Zeitaufwand verringert. Die feinstufige Veränderbarkeit der Vorschublänge führt auch dazu, dass die Mittellage von stark unterschiedlich langen Bauteilen ohne zusätzlichen Vorrichtungsaufwand auf stets die gleiche Abholposition eingestellt werden kann.

Nach einer vorteilhaften Weiterbildung der Erfindung weist der Antrieb ein mit dem Gurt koppelbares Antriebsrad auf, das mit einer Winkelskala versehen ist und ist die Zuführeinrichtung mit einer entsprechenden Abtasteinrichtung versehen. Durch die unmittelbare Zuordnung dieses Encoders zum Antriebsrad wird die Positionserfassung am unmittelbaren Antriebselement durchgeführt. Motor und Getriebetoleranzen werden dabei vollständig ausgeschaltet. Die Winkelskala kann z. B. eine optische oder magnetische Markierung aufweisen, die mit einem entsprechenden Lesekopf abgetastet wird.

Nach einer anderen Weiterbildung der Erfindung ist eine Vielzahl der Zuführeinrichtungen auf einem Träger senkrecht zur Vorschubrichtung aneinandergereiht und sind die Abholstellen der einzelnen Zuführeinrichtungen auf einer geraden Linie ausrichtbar. Dadurch ist es möglich, einen Bestückkopf über den Abholstellen in einer stationären Längsführung zu verfahren, wie dies z. B. in der EP 0373373 B1 (Figuren 5 bis 7) dargestellt ist, ohne dass es dabei erforderlich ist, die Stellung der Pipette in der Förderrichtung der tatsächlichen Abhollage anzupassen.

Gemäß einem Verfahren zum Zuführen der Bauteile nach Anspruch 4 wird die Lage der Bauteile in der Abholposition mittels einer Messeinrichtung ermittelt und wird die Abhollage der Bauteile durch Verändern der Halteposition des Antriebs korrigiert. Durch das Vermessen der bereitliegenden Bauteile bzw. der zugehörigen Gurttasche können Lageabweichungen in der Zuführeinrichtung und auch im Gurt selbst erfasst und durch das Nachführen der Halteposition kompensiert werden.

Im folgenden wird die Erfindung anhand eines in der Zeichnung dargestellten Ausführungsbeispiels näher erläutert.
- Figur 1: zeigt eine Seitenansicht eines Bestückkopfes und einer teilweise aufgebrochenen Zuführeinrichtung mit einem Bauteilegurt,
- Figur 2: eine Draufsicht auf die Zuführeinrichtung nach Figur 1.

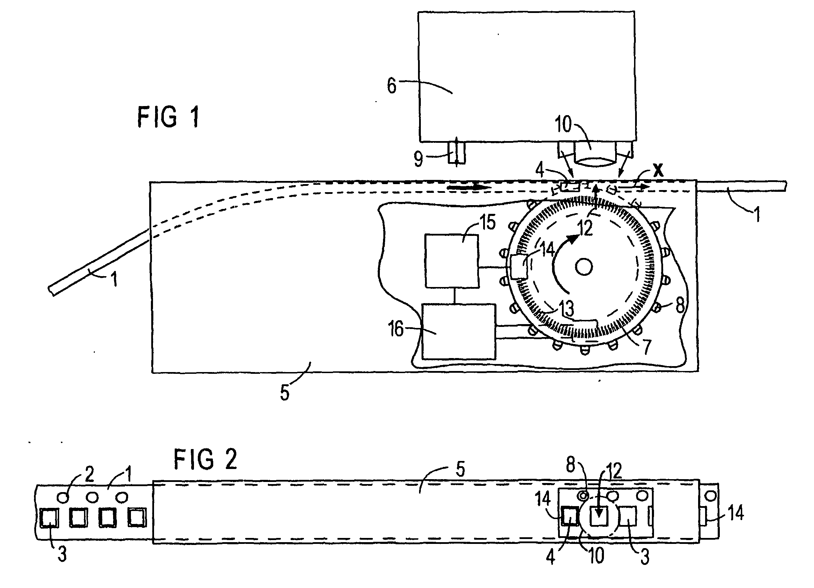

Nach den Figuren 1 und 2 ist ein bandartiger Gurt 1 mit seitlichen Transportlöchern 2 und Taschen 3 für darin eingelegte Bauteile 4 versehen und in eine scheibenartig flache Zuführeinrichtung 5 eingesetzt, die in einer definierten Lage im Verfahrbereich eines Bestückkopfes 6 einer Bestückvorrichtung fixiert ist. Die Zuführeinrichtung 5 weist ein schrittweise antreibbares Antriebsrad 7 mit peripher abstehenden Transportstiften 8 auf, die in die Transportlöcher 2 des Gurtes 1 spielfrei eingreifen. Die Lagebeziehung zwischen den Taschen und den Transportlöchern ist durch einschlägige Normen festgelegt. Die zusätzlichen Toleranzen sind hier jedoch nahezu so groß, wie die Seitenabmessungen der kleinsten Bauteile.

Der Bestückkopf weist auf seiner dem Gurt zugewandten Unterseite einen Sauggreifer 9 und eine Abtastoptik 10 in Form einer CCT-Kamera auf, deren Objektiv von einer Beleuchtung 11 umgeben ist, die das Sichtfeld der Abtastoptik 10 ausleuchtet. Die Beleuchtung 11 kann z. B. aus einer Vielzahl von Leuchtdioden unterschiedlicher Wellenlängen und unterschiedlicher Orientierung bestehen. In Anpassung an die verschiedenen Gurttypen ist es möglich, eine günstige Auswahl der Dioden so anzusteuern, dass die Strukturmerkmale des Gurtes bzw. der Bauteile kontrastreich hervortreten und sicher erkannt werden können.

Die Abtastoptik 10 ist auf eine Abholstelle 12 der Bauteile in Zuführeinrichtung 5 gerichtet. Sie ist in der Lage, Strukturmerkmale 14, z. B. die Ränder einer leeren Tasche zu erkennen. Sie ist mit einer Bildauswerteeinheit 13 verbunden, die anhand dieser Daten die Mittellage der Tasche berechnet. Über einen längeren Abschnitt des Gurtes wird sich die Lage der Tasche 3 in Bezug auf das Transportloch wenig verändern. Das heißt, dass die gemessenen Werte über eine längere Folge von Taschen für die Abholkorrektur verwendet werden können.

Sollte sich die Zahl der Abhohlfehler erhöhen, so kann der Messvorgang erneut durchgeführt werden, um die geänderte Abhollage ermitteln zu können.

Das Antriebsrad ist auf seiner flachen Seite mit einer umlaufenden Winkelskala 13 in Form einer magnetisierten Folie versehen. Ein darauf gerichteter stationär angeordneter Lesekopf 14 ist in der Lage, die Winkelstellung des Antriebsrades zu detektieren und einer Steuereinrichtung 15 zu übermitteln. Diese steuert im darauffolgenden Antriebsschritt einen Antriebsmotor 16 derart, dass die Vorschublänge um den ermittelten Korrekturbetrag verändert wird. In den nachfolgenden Vorschubschritten kann dann ein gleichbleibender Teilungsabstand eingehalten werden.

### Bezugszeichenliste

- 1: Gurt
- 2: Transportloch
- 3: Tasche
- 4: Bauteile
- 5: Zuführeinrichtung
- 6: Bestückkopf
- 7: Antriebsrad
- 8: Transportstift
- 9: Sauggreifer
- 10: Abtastoptik
- 11: Beleuchtung
- 12: Abholstelle
- 13: Winkelskala
- 14: Lesekopf
- 15: Steuereinrichtung
- 16: Motor

## Patentansprüche

1. Einrichtung zum Zuführen von gegurteten elektrischen Bauteilen (4) in einer Zuführeinrichtung (5) mit einem Antrieb zum Vorschieben eines die Bauteile (4) aufnehmenden Gurtes (1),
wobei die Bauteile (4) in Taschen des Gurtes (1) aufgenommen und schrittweise in eine definierte Abhollage transportierbar sind
wobei der Antrieb einen Motor (16) und ein von diesem angetriebenes Antriebsrad (7) aufweist,
wobei der Gurt (1) mit Transportlöchern (2) versehen ist, die in die Transportstifte (8) des Antriebsrades (7) eingreifen und
wobei der Antrieb mit einer Steuereinrichtung zum Verändern der Vorschublänge versehen ist.
**dadurch gekennzeichnet , dass** die Steuereinrichtung Mittel zum feinstufigen regelbaren Verändern der Vorschublänge um kleine Korrekturschritte aufweist.

2. Einrichtung nach Anspruch 1,
**dadurch gekennzeichnet, dass** das Antriebsrad (7) mit einer feinstufigen Winkelskala (13) versehen ist und
dass die Zuführeinrichtung einen entsprechenden Lesekopf (14) aufweist.

3. Einrichtung nach Anspruch 1 oder 2,
**dadurch gekennzeichnet,**
**dass** eine Vielzahl der Zuführeinrichtungen (5) auf einem Träger senkrecht zur Vorschubrichtung aneinandergereiht angebracht sind und dass die Abholstellen (12) der einzelnen Zuführeinrichtungen (5) auf eine gerade Linie ausrichtbar sind.

4. Verfahren zum Zuführen von gegurteten elektrischen Bauteilen (4) mittels einer Zuführeinrichtung nach Anspruch 1, 2 oder 3, in einer Vorrichtung zum Bestücken von Substraten mit den Bauteilen (4),
wobei ein die elektrischen Bauteile (4) aufnehmender Gurt (1) mittels eines Antriebs der Zuführeinrichtung (5) schrittweise vorgeschoben wird und
wobei den Abholstellen (12) der Bauteile (4) zugeordneten Strukturmerkmale mittels einer Messeinrichtung (z. B. 10) der Bestückvorrichtung optisch abgetastet werden,
**dadurch gekennzeichnet, dass** die Messeinrichtung unmittelbar auf die Taschen des Gurtes (1) gerichtet wird und die genaue Abhollage der Bauteile (4) ermittelt und
dass die Abhollage der Bauteile (4) durch Verändern der Halteposition des Antriebs korrigiert wird.

## Claims

1. Device for feeding taped electrical components (4) in a feed device (5) with a drive for feeding a tape (1) accommodating the components (4), in which case the components (4) are accommodated in pockets of the tape (1) and can be transported stepwise into a defined picking position, in which case the drive has a motor (16) and a drive gear (7) driven by this, in which case the tape (1) has transport holes (2) into which the transport pins (8) of the drive wheel (7) engage and in which case the drive has a control device for changing the length of the feed,
**characterized in that** the control unit has means for fine adjustments to the feed length by means of small corrective steps.

2. Device according to Claim 1,
**characterized in that** the drive wheel (7) is provided with an angle scale (13) providing fine graduations and that the feed device is provided with a corresponding reading head (14).

3. Device according to Claim 1 or 2,
**characterized in that** a large number of feed devices (5) are arranged alongside one another on a carrier vertical to the feed direction and the picking points (12) of the individual feed devices (5) can be aligned in one straight line.

4. Method for feeding taped electrical components (4) by means of a feed device according to Claim 1, 2 or 3 in a device for equipping substrates with the components (4), where a tape (1) accommodating the electrical components (4) is advanced in steps by means of a drive of the feed device (5) and in which case the structure features allocated to the picking points (12) of the components (4) are scanned optically by means of a measuring device (e.g. 10) of the placement device, **characterized in that** the measuring device is aimed directly at the pockets of the tape (1) and determines the exact picking position of the components (4) and that the picking position of the components (4) is corrected by changing the stop position of the drive.

## Revendications

1. Dispositif pour l'alimentation de composants électriques sur bande (4) dans un dispositif d'alimentation (5) équipé d'un entraînement pour faire avancer une bande (1) recevant les composants (4), les composants (4) étant reçus dans des poches de la bande (1) et pouvant être transportés pas à pas dans une position d'enlèvement définie, l'entraînement présentant un moteur (16) et une roue d'entraînement (7) entraînée par celui-ci, la bande (1) étant pourvue d'orifices de transport (2), qui engrènent dans les ergots de transport (8) de la roue d'entraînement (7) et l'entraînement étant pourvu d'un dispositif de commande pour modifier la longueur d'avance, **caractérisé en ce que** le dispositif de commande comporte des moyens pour modifier la longueur d'avance par un réglage fin, réglable en petites étapes de correction.

2. Dispositif selon la revendication 1, **caractérisé en ce que** la roue d'entraînement (7) est pourvue d'une échelle angulaire de réglage fin (13) et **en ce que** le dispositif d'alimentation présente une tête de lecture correspondante (14).

3. Dispositif selon la revendication 1 ou 2, **caractérisé en ce qu'**une pluralité des dispositifs d'alimentation (5) sont mis l'un à côté de l'autre sur un support au droit de la direction de l'avance et **en ce que** les points d'enlèvement (12) des dispositifs d'alimentation individuels (5) peuvent être alignés sur une ligne droite.

4. Procédé par alimentation de composants électriques sur bande (4) au moyen d'un dispositif d'alimentation selon la revendication 1, 2 ou 3, dans un appareil pour l'équipement de substrats avec des composants (4), une bande (1) recevant les composants électriques (4) étant faite avancer pas à pas au moyen d'un entraînement du dispositif d'alimentation (5) et les caractéristiques structurelles affectées aux points d'enlèvement (12) des composants (4) étant balayées optiquement au moyen d'un dispositif de mesures (par ex. 10) de l'appareil d'équipement, **caractérisé en ce que** le dispositif de mesure est dirigé directement sur les poches de la bande (1) et **en ce qu'**il détermine la position d'enlèvement précise des composants (4) et **en ce que** la position d'enlèvement des composants (4) est corrigée en modifiant la position d'arrêt de l'entraînement.
